# EUROPÄISCHE PATENTSCHRIFT

(11) **EP 1 965 625 B1**
(45) Veröffentlichungstag und Bekanntmachung des Hinweises auf die Patenterteilung: **28.10.2015**
(21) Anmeldenummer: 08100493.9
(22) Anmeldetag: 15.01.2008
(51) Int. Cl.: H05K 7/14

(54) **Varioträger**
Variable support
Support variable

(30) Priorität: 01.03.2007 DE 102007010042; 13.09.2007 DE 202007012830 U
(43) Veröffentlichungstag der Anmeldung: 03.09.2008
(73) Patentinhaber: Fujitsu Technology Solutions Intellectual Property GmbH, 80807 München (DE)
(72) Erfinder: Blume, Johannes, 33034 Brakel (DE); Fietz, Ralf-Peter, 33104 Paderborn (DE)
(74) Vertreter: Epping - Hermann - Fischer

(56) Entgegenhaltungen:
- WO-A1-2004/000078
- DE-U1-202006 015 751
- US-A1- 2001 040 203
- US-A1- 2004 016 712

## Beschreibung

Die Erfindung betrifft einen Varioträger zur Montage an vertikalen Trägerprofilen eines Racks, wobei die vertikalen Trägerprofile des Racks Öffnungen in einem standardisierten Raster aufweisen und der Varioträger über die Öffnungen an den vertikalen Trägerprofilen festlegbar ist.

Die Öffnungen in den vertikalen Trägerprofilen weisen in Europa quadratische Öffnungen mit einem Maß von 9 x 9 mm beziehungsweise 9,5 x 9,5 mm auf. In den USA sind die Öffnungen ebenfalls standardisiert, wobei hier ein Rundlochraster verwendet wird. Bisher werden die Trägersysteme beziehungsweise die Varioträger manuell über Schrauben mit den vertikalen Trägerprofilen verschraubt. Um die Montage zu vereinfachen, ist es wünschenswert, die Varioträger auch schraubenlos an den vertikalen Trägerprofilen der Racks festlegen zu können.

Aus der US 6,659,557 B2 ist ein System bekannt, bei dem an dem Varioträger ein Winkel mit nach innen weisenden Vorsprüngen angeschraubt ist, welcher von außen in die Öffnungen der vertikalen Trägerprofile gesteckt werden kann. Um ein Herausrutschen aus den Öffnungen zu verhindern, wird von innen ein Anschlag in Position gebracht und mit einer Schraube fixiert, sodass ein Herausrutschen der Fortsätze aus den Öffnungen nach außen verhindert wird.

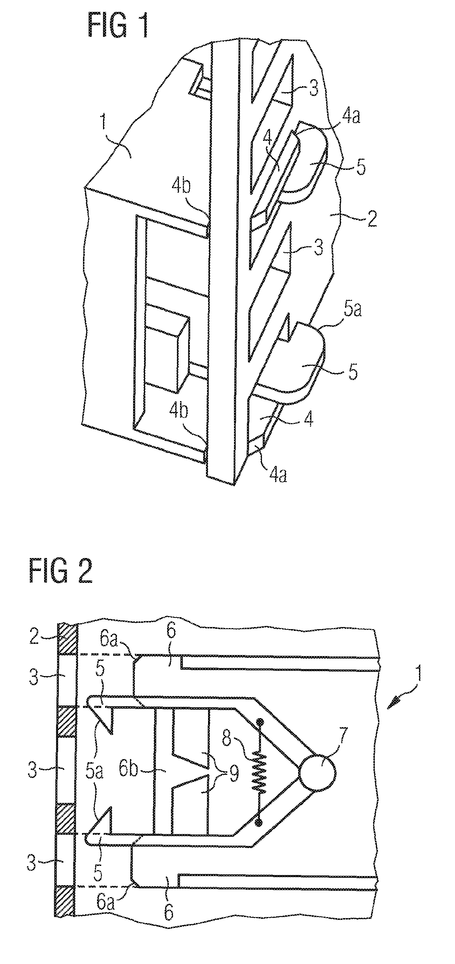

Die US 6,230,903 B1 offenbart eine alternative Lösung für eine schraubenlose Montage eines Varioträgers. Gemäß der Ausführungsform nach Figur 2 werden an einer Teleskopschiene zwei Schienen angeschraubt, welche ebenfalls endseitig nach innen vorspringende Fortsätze aufweisen und in die Öffnungen der vertikalen Trägerprofile von außen eingreifen können. Um ein Herausrutschen der Fortsätze aus den Öffnungen der vertikalen Trägerprofile zu vermeiden, werden die Schienen an einem durchgehend starren Teil der Teleskopschiene fixiert. Das Ausführungsbeispiel gemäß Figur 5 ist prinzipiell analog aufgebaut, wobei hier die Fortsätze von innen nach außen weisen, sodass die Fortsätze auch von innen nach außen durch die Öffnungen in die vertikalen Trägerprofilen zur Festlegung der Teleskopschiene gesteckt werden.

Nachteilig an diesen beiden Lösungen ist immer noch die relativ aufwändige Montage, da immer im eingesteckten Zustand der Vorsprünge in die Öffnungen bei der US 6,659,577 ein Anschlag angeschraubt werden muss und bei der US 6,230,903 die Schienen an durchgehenden Teile der Teleskopschiene befestigt werden müssen. Dies bedeutet, dass bei dieser Verschraubung die Gefahr besteht, dass die Vorsprünge wieder leicht aus den Öffnungen rutschen beziehungsweise man bei der Montage sehr darauf bedacht sein muss, dass auch bei leicht angezogenen Schrauben noch mal geprüft wird, dass die Vorsprünge komplett in die Öffnungen eingreifen und erst danach die Verschraubung festgezogen wird.

In der US 2001/0040203 A1 ist ein Varioträger zur Montage an einem vertikalen Trägerprofil offenbart. Dieser Varioträger weist zwei starre Haken und einen federbelasteten Riegel auf. Der federbelasteten Riegel lässt sich beim Einhängen der zwei starren Haken in den Öffnungen des Trägerprofils zurückschieben und nachdem die zwei starren Haken eingehängt sind, springt der Riegel in einer entsprechenden Öffnung im vertikalen Trägerprofil zurück, um den Varioträger gegen das Aus hängen der Haken zu schützen und damit den Varioträger zu fixieren.

In der DE 20 2006 015 751 U1 wird ein Varioträger mit zwei Hängeelementen und einem starren Haken zum Einstecken in drei Öffnungen eines vertikalen Trägerprofils beschrieben. Der starre Haken ist zwischen den Hängeelementen angeordnet. Die Hängeelemente und der Haken werden von außen durch die drei Öffnungen gesteckt und durch ein federbelastetes Sperrelement von innen fixiert. Das Sperrelement ist nicht als Haken ausgebildet. Das Sperrelement wird beim Einstecken zusammengedrückt und rastet nach dem Einstecken in dem starren Haken ein.

Nach der US 2004/0016712 A1 wird ein Varioträger ebenso von außen in die Öffnungen eines vertikalen Trägerprofils eingesteckt. Hier weist der Varioträger zwei stufenförmige Verlängerungen auf, die im montierten Zustand hinter der jeweiligen Öffnung des Trägerprofils greifen. Der Varioträger wird durch einen federbelasteten Riegel fixiert, der in eine oder zwei Öffnungen des Trägerprofils einrastet.

Nachteilig an diesen Lösungen ist die Gefahr, dass die eingesteckten Teile bei der Montage leicht verkeilen können und abbrechen. Zusätzlich werden mindestens drei Teile in den Öffnungen des Trägerprofils eingesteckt. Das heißt, die Abstände zwischen drei Teile müssen untereinander stimmen. Dies bedeute eine erhöhte Anforderung an die Herstellung.

Die WO 2004/000078 A1 beschreibt eine Befestigung für einen Varioträger, die einen starren Haken und einen beweglichen Haken aufweist. Der bewegliche Haken ist nicht federbelastet, sondern wird durch einen Hebel zwischen zwei Stellungen (näm lich verriegelt und entriegelt) bewegt. Eine Schwebeachse, die mit einem Dichtungsgummi ausgestattet ist, und eine Führungsöffnung für den Hebel in der Form eines Bumerangs sorgen dafür, dass der Hebel nur zwischen diesen zwei Stellungen pendelt.

Der Erfindung liegt die Aufgabe zugrunde, eine Lösung für die die Montage eines Varioträgers an vertikalen Trägerprofilen eines Racks aufzuzeigen, welches eine leichtere Montage des Varioträgers erlaubt.

Diese Aufgabe wird erfindungsgemäß dadurch gelöst, dass der Varioträger eine Rasteinrichtung aufweist, die als federbelasteter Haken ausgebildet ist und welche beim Einschieben in eine der Öffnungen an den vertikalen Trägerprofilen automatisch verrastet, wobei der Haken bei der Montage des Varioträgers von innen durch eine Öffnung des Trägerprofils gesteckt wird und im montierten Zustand den Rand der Öffnung hintergreift.

Durch das automatische Verrasten der Rasteinrichtung beim Einschieben in eine der Öffnungen an den vertikalen Trägerprofilen wird erzielt, dass der Varioträger über den Rastbeziehungsweise Schnappmechanismus einfach von einer Person am vertikalen Trägeprofil festgelegt werden kann.

Die Varioträger sind vorzugsweise in ihrer Länge verstellbar, sodass die Person, welche den Varioträger montiert, lediglich erst auf der einen Seite den Varioträger über die Schnappverbindung in den Öffnungen des vertikalen Trägerprofils festlegt und danach auf der gegenüberliegenden Seite eine weitere Schnappverbindung oder einen hervorstehenden Balken in die Öffnung des vertikalen Trägerprofils einsteckt. Die Montage des Varioträgers ist somit extrem einfach und kann schrauben- und werkzeuglos erfolgen.

Gemäß einer bevorzugten Ausführungsform sind am Varioträger stirnseitig Zentrierelemente vorgesehen, die von innen in die Öffnungen der vertikalen Trägerprofile des Racks im montierten Zustand eingreifen. Diese Zentrierelemente sind vorzugsweise einstückig am Varioträger selbst ausgebildet und können als horizontale oder vertikale Blechlaschen oder auch als runde Zentrierbolzen ausgeformt sein. Vertikale Blechlaschen haben den Vorteil erhöhter Stabilität im Vergleich zu den horizontalen Blechlaschen. Die horizontalen Blechlaschen hingegen erlauben eine Justierung des aufgenommenen Varioträgers in der Höhe innerhalb der Öffnung des Trägerprofiles.

Die Ausbildung des Zentrierelementes als runder Zentrierbolzen hat den Vorteil, dass in den quadratischen Öffnungen über den runden Zentrierbolzen eine Zentrierung nach oben, nach unten sowie auch seitlich erfolgt und somit der Varioträger ideal zentriert an den Trägerprofilen des Racks festgelegt ist.

Gemäß einer bevorzugten Ausführungsform sind pro Varioträger zwei übereinander angeordnete runde Zentrierbolzen vorgesehen, sodass der Varioträger optimal zentriert und auch bezüglich Verwindungen fix in den Öffnungen der Trägerprofile des Racks aufgenommen ist.

Gemäß einer bevorzugten Weiterbildung ist einer der Zentrierbolzen hohl ausgebildet und die Rasteinrichtung innerhalb des Zentrierbolzens angeordnet.

Durch die Ausbildung der Rasteinrichtung innerhalb des Zentrierbolzens ist es möglich, bei optimaler Zentrierung des Varioträgers eine automatische Montage zu erlauben.

Gemäß einer bevorzugten Ausführungsform ist die Rasteinrichtung als federbelasteter Haken ausgebildet, der bei der Montage des Varioträgers an die Trägerprofile des Racks von innen durch die Öffnung einer Trägersäule des Racks gesteckt wird und im montierten Zustand den Rand der Öffnung hintergreift.

Vorzugsweise weist der Haken stirnseitig eine Schräge auf, sodass er beim Anstecken des Varioträgers an das Trägerprofil automatisch ausfedert und ein Durchführen des Hakens durch die Öffnung des Trägerprofils erlaubt.

Für die Demontage ist vorzugsweise am federbelasteten Haken ein Entriegelungsvorsprung vorgesehen, welcher von der Frontseite des Racks über eine benachbarte Öffnung im Trägerprofil, neben der Öffnung mit dem aufgenommenen Haken manuell oder mit einem Stift entriegelt werden kann.

Sind keine Einschubeinheiten am Varioträger befestigt, kann die Entriegelung natürlich auch manuell seitlich von innen erfolgen.

Prinzipiell ist es ausreichend, nur eine Rastvorrichtung am Varioträger vorzusehen. Bei dieser Ausbildung ist nur ein federbelasteter Haken an einem Stirnende des Varioträgers angeordnet. Die Varioträger sind in ihrer Länge verstellbar und am anderen Ende ist entweder auch eine Rasteinrichtung vorgesehen oder nur Zentrierelemente.

Gemäß einer Weiterbildung der Erfindung sind an dem Varioträger zwei übereinander angeordnete federbelastete Haken vorgesehen, welche entweder so federbelastet sind, dass sie sich aufeinander zu bewegen oder sich parallel zueinander bewegen und die Öffnungen beziehungsweise die Trägerprofile an den Öffnungen seitlich hintergreifen. Sämtliche Ausbildungen der Rasteinrichtungen und Zentrierelemente können auch gemischt am Varioträger je nach Erfordernis für den Anwendungsfall vorgesehen sein.

Weitere Vorteile der Erfindung beziehungsweise vorteilhafte Ausgestaltungen ergeben sich aus den Unteransprüchen sowie der nachfolgenden Figurenbeschreibung.

Nachfolgend wird anhand vier in den Figuren dargestellter Ausführungsbeispiele die Erfindung näher erläutert. In den Figuren zeigen:
- Figur 1: in Schrägansicht ein Ausschnitt der Stirnseite eines Varioträgers montiert an einem vertikalen Trägerprofil eines Racks gemäß einem ersten Ausführungsbeispiel der Erfindung,
- Figur 2: zeigt in Seitenansicht die Stirnseite eines Varioträgers sowie in Schnittansicht der Ausschnitt aus dem Trägerprofil eines Racks gemäß einem zweiten Ausführungsbeispiel der Erfindung,
- Figur 3A: zeigt die Ansicht gemäß Figur 2 bezüglich eines dritten Ausführungsbeispiels der Erfindung,
- Figur 3B: zeigt die Stirnseite des Varioträgers gemäß Figur 3A,
- Figur 4A: zeigt ebenso die Ansicht gemäß Figur 2 beziehungsweise Figur 3A gemäß einem vierten Ausführungsbeispiel der Erfindung und
- Figur 4B: zeigt die Stirnseite des Varioträgers gemäß Figur 4A.

Figur 1 zeigt in einem Ausschnitt in Schrägansicht einen Varioträger 1, welcher an einem Trägerprofil 2 eines Racks, in der Regel ein Serverrack, festgelegt ist. Von den Trägerprofilen 2 sowie auch von dem Varioträger 1 ist nur ein geringer Ausschnitt dargestellt. Das Trägerprofil 2 weist im Raster angeordnete standardisierte Öffnungen 3 auf, welche in Europa das Maß 9 x 9 mm beziehungsweise 9,5 x 9,5 mm haben. Der Varioträger 1 dient zur Befestigung der Einschübe beziehungsweise der Teleskopschienen in Serverracks. Der Varioträger 1 ist in seiner Länge verstellbar und wird entweder federbelastet zwischen die Trägerprofile 2 eingespannt oder er wird auseinander gezogen an den Trägerprofilen 2 arretiert und dann auch in seiner Länge zum Beispiel über eine Spannschraube fixiert.

Im dargestellten Ausführungsbeispiel geht es um die Montage des Varioträgers 1 am Trägerprofil 2, insbesondere um die Zentrierung und die Fixierung.

Für die Aufnahme der Stirnseite des Varioträgers 1 in den Öffnungen 3 des Trägerprofils 2 sind an dem Varioträger 1 horizontale Blechlaschen 4 ausgebildet. Die horizontalen Blechlaschen 4 sind stirnseitig mit einer kleine Phase 4a versehen, welche ein leichteres Einführen in die Öffnungen 3 ermöglicht. Des Weiteren sind die Blechlaschen 4 in der Breite so ausgebildet, dass sie exakt die Breite der Öffnungen 3 ausfüllen. Dadurch wirken die Blechlaschen 4 als Zentrierelemente für den Varioträger 1.

Um eine definierte Montageposition zu erreichen, ist zwischen den Blechlaschen 4 und dem Varioträger selbst ein Anschlag 4b ausgebildet, welche im montierten Zustand an der Innenseite des Trägerprofils 2 anliegt.

Als Rasteinrichtung sind gemäß dieser Ausführungsform zwei federbelastete Haken 5 vorgesehen, welche an der äußeren Stirnseite mit einer Abrundung beziehungsweise einer Phase 5a ausgebildet sind. Beim Einschieben des Varioträgers 1 in das Trägerprofil 2 werden durch die Phase 5a die federbelasteten Haken zurückgedrängt, sodass sie durch die Öffnungen 3 geschoben werden können und erst nach vollständigem Einschieben des Varioträgers 1, das heißt wenn der Anschlag 4b an der Innenseite des Trägerprofils 2 anliegt, schnappen die Haken 5 wieder in ihre ursprüngliche Position und hintergreifen seitlich der Öffnungen 3 das Trägerprofil 2. Die Haken bilden somit eine Rasteinrichtung und verhindern das Herausziehen des Varioträgers 1 aus dem Trägerprofil 2. Im dargestellten Ausführungsbeispiel sind zwei Haken übereinander angeordnet, wobei diese horizontal nach innen bei einem aufgestellten Rack wirken.

Zum Lösen der Rasteinrichtung beziehungsweise der Haken 5 werden diese lediglich manuell wieder verschoben, sodass sie durch die Öffnungen 3 geschoben werden können.

Figur 2 zeigt eine alternative Ausführungsform der Erfindung. Sämtliche Bauteile beziehungsweise Elemente mit gleicher Funktion sind in Figur 2 sowie in den nachfolgenden Figuren mit den gleichen Bezugszeichen wie zu Figur 1 versehen.

In Figur 2 ist der Varioträger 1 beziehungsweise die Stirnseite des Varioträgers 1 aus der Sicht auf die Innenseite des Varioträgers 1 dargestellt und das Trägerprofil 2 im Schnitt. Der Varioträger 1 und das Trägerprofil 2 sind noch nicht miteinander verbunden.

Im Vergleich zu der Ausführungsform gemäß Figur 1 sind bei der Ausführungsform gemäß Figur 2 am Varioträger 1 senkrechte Blechlaschen 6 an der Stirnseite des Varioträgers 1 angebracht.

Die senkrechten Blechlaschen 6 können in die Öffnungen 3 der Trägerprofile 2 eingeschoben werden. Diese sind stirnseitig ebenfalls mit Phasen 6a versehen und der Bereich zwischen den beiden Blechlaschen 6 dient als Anschlag 6b.

Die beiden Haken 5 sind über eine gemeinsame Achse 7 am Varioträger 1 festgelegt und gegenseitig durch eine Feder 8 so vorgespannt, dass die Haken 5 beim Einstecken in die Öffnungen 3 durch die Phasen 5a leicht ausfedern und die Haken 5 durch die Öffnungen 3 gesteckt werden können.

Zwischen den Haken 5 ist jeweils ein Entriegelungsvorsprung 9 vorgesehen, über welchen durch eine Öffnung 3 mit einem spitzen Gegenstand, wie zum Beispiel einem Schraubenzieher, die Haken 5 entgegen der Kraft der Feder 8 nach außen bewegt werden können und somit der Varioträger 1 aus dem Trägerprofil 2 gezogen werden kann.

Im dargestellten Ausführungsbeispiel sind die Haken 5 so angeordnet, dass der obere Haken mit seinem Vorsprung nach unten und der untere mit seinem Vorsprung nach oben zeigt und somit beide durch eine gemeinsame Feder 8 federbeaufschlagt sein können.

Ebenso ist es jedoch möglich, beide Haken 5 in der gleichen Wirkrichtung anzuordnen und mit separaten Federn zu beaufschlagen.

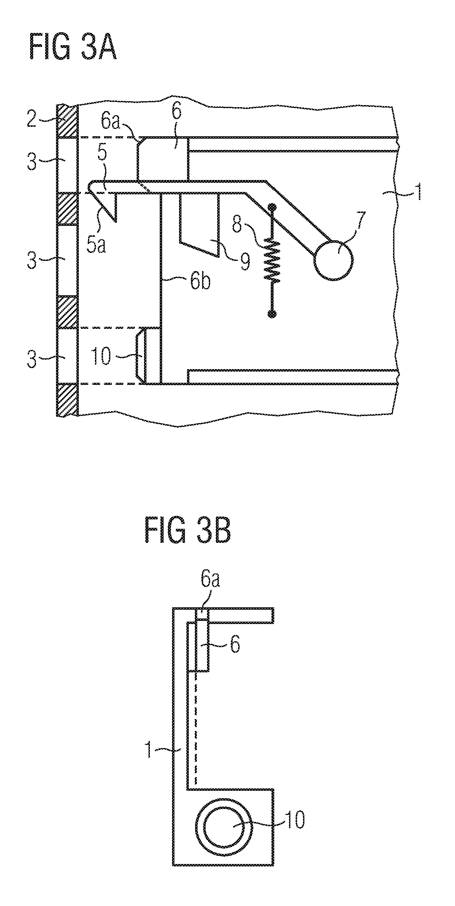

Figur 3A zeigt ein weiteres Ausführungsbeispiel der Erfindung, wobei hier wieder ebenso wie in Figur 2 auf der linken Seite das Trägerprofil 2 mit den Öffnungen 3 und auf der rechten Seite der Varioträger 1 mit nur einem durch die Feder 8 vorgespannten Haken 5 vorgesehen ist. An dem Haken 5 ist wiederum die Achse 7 schwenkbar angeordnet und am Haken 5 ist ein Entriegelungsvorsprung 9 vorgesehen, welcher durch die mittlere Öffnung 3 über einen länglichen Gegenstand betätigt werden kann.

An der oberen Seite des Varioträgers 1 ist als Zentrierelement eine vertikale Blechlasche 6 angeordnet, und an der unteren Seite des Varioträgers 1 im Gegensatz zu Figur 2 ein runder Zentrierbolzen 10.

Der Zentrierbolzen 10 hat den Vorteil, dass der Varioträger auch in horizontaler Richtung exakt positioniert und in seiner Lage bezüglich des Trägerprofils 2 zentriert ist.

Figur 3B zeigt die Ansicht des Varioträgers 1 ohne aufgenommene Rasteinrichtungen in der Ansicht von vorne.

Der Zentrierbolzen 10 ist in seinem Querschnitt so gewählt, dass er die gesamte Öffnung 3 ausfüllt und somit den Varioträger 1 an der Unterseite exakt zentriert. Damit der Varioträger 1 senkrecht aufgenommen wird, ist an der Oberseite die Lasche 6 so weit nach innen gerückt, dass die Außenkante der Lasche 6 mit der Außenkante des Zentrierbolzens 10 fluchtet.

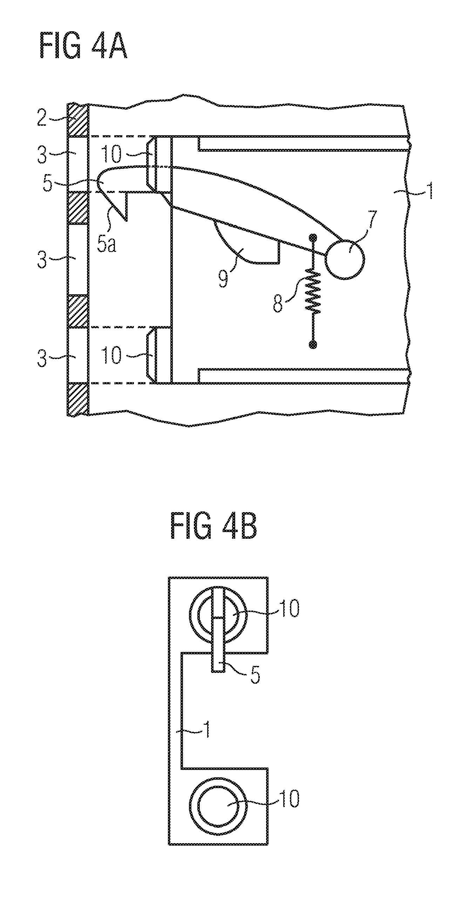

Eine weitere Ausführungsform der Erfindung ist in Figur 4A und Figur 4B dargestellt. Die Figuren 4A und 4B zeigen im Wesentlichen die gleichen Ansichten wie die Figuren 3A und 3B, wobei gemäß der Ausführungsform gemäß Figur 4A und 4B anstatt der oberen Blechlasche ebenso ein Zentrierbolzen 10 vorgesehen ist, welcher hohl ausgebildet ist und die Rasteinrichtung in Form des Feder belastenden Hakens 5 ist bei der Ausführungsform gemäß Figur 4A und 4B innerhalb des oberen hohlen Zentrierbolzens 10 angeordnet ist. Für die Montage wird der Varioträger 1 mit den beiden Zentrierbolzen 10 in die Öffnungen 3 des Trägerprofils 2 gesteckt, wobei dann über die Phase 5a der Haken entgegen der Kraft der Feder 8 angehoben wird und nach dem vollkommenen Einstecken wieder ausfedert und die Öffnung 3 an der Unterseite hintergreift. Durch die beiden Zentrierbolzen an der Ober- und Unterseite ist der Varioträger 1 ideal und auch verwindungssicher zentriert und der federbelastete Haken 5 erlaubt eine einfache Montage lediglich durch Einstecken des Varioträgers 1 in das Trägerprofil 2.

### Bezugszeichenliste

- 1: Varioträger
- 2: Trägerprofil
- 3: Öffnungen
- 4: Blechlasche
- 4a: Phase
- 4b: Anschlag
- 5: Haken
- 5a: Phase
- 6: vertikale Blechlasche
- 6a: Phase
- 6b: Anschlag
- 7: Achse
- 8: Feder
- 9: Entriegelungsvorsprung
- 10: Zentrierbolzen

## Patentansprüche

1. Varioträger (1) zur Montage am vertikalen Trägerprofil (2) eines Racks, wobei die vertikalen Trägerprofile (2) des Racks Öffnungen (3) in einem standardisierten Raster aufweisen und der Varioträger (1) über die Öffnungen (3) an den vertikalen Trägerprofilen (2) festlegbar ist, **dadurch gekennzeichnet, dass**
der Varioträger (1) eine Rasteinrichtung aufweist, die als federbelasteter Haken (5) ausgebildet ist und welche beim Einstecken in eine der Öffnungen (3) an den vertikalen Trägerprofilen (2) automatisch verrastet, wobei der Haken bei der Montage des Varioträgers (1) von innen durch eine Öffnung (3) des Trägerprofils (2) gesteckt wird und im montierten Zustand den Rand der Öffnung (3) hintergreift.

2. Varioträger (1) nach Anspruch 1,
**dadurch gekennzeichnet, dass**
der Varioträger (1) stirnseitig wenigstens ein Zentrierelement aufweist, das von innen in die Öffnung (3) des vertikalen Trägerprofils (2) des Racks eingreift.

3. Varioträger (1) nach Anspruch 2,
**dadurch gekennzeichnet, dass**
das Zentrierelement als horizontale Blechlasche (4) des Varioträgers (1) ausgebildet ist.

4. Varioträger (1) nach Anspruch 2,
**dadurch gekennzeichnet, dass**
das Zentrierelement als vertikale Blechlasche (6) des Varioträgers (1) ausgebildet ist.

5. Varioträger (1) nach Anspruch 2,
**dadurch gekennzeichnet, dass**
das Zentrierelement als runder Zentrierbolzen des Varioträgers (1) ausgebildet ist.

6. Varioträger (1) nach Anspruch 2,
**dadurch gekennzeichnet, dass**
das Zentrierelement als hohler Zentrierbolzen (10) des Varioträgers ausgebildet ist und die Rasteinrichtung zum Teil innerhalb des Zentrierbolzens (10) angeordnet ist.

7. Varioträger (1) nach einem der vorhergehenden Ansprüche,
**dadurch gekennzeichnet, dass**
der federbelastete Haken (5) einen Entriegelungsvorsprung (9) aufweist, sodass der Haken (5) von der Vorderseite des Trägerprofils durch eine Öffnung (3) entriegelt werden kann.

8. Varioträger (1) nach einem der vorhergehenden Ansprüche,
**dadurch gekennzeichnet, dass**
die Rasteinrichtung zwei Haken (5) senkrecht gegenüberliegend aufweist, welche durch eine gemeinsame Feder (8) vorgespannt sind.

9. Varioträger (1) nach einem der Ansprüche 1 bis 7,
**dadurch gekennzeichnet, dass**
die Rasteinrichtung zwei Haken (5) senkrecht übereinander mit horizontaler Bewegungsrichtung der Haken relativ zum Varioträger (1) aufweist.

## Claims

1. Variable support (1) for mounting on a vertical support profile (2) of a rack, wherein the vertical support profiles (2) of the rack have openings (3) in a standardized grid, and the variable support (1) by way of the openings (3) is fixable to the vertical support profiles (2), **characterized in that** the variable support (1) has a latching installation which is configured as a spring-loaded hook (5) and which upon insertion into one of the openings (3) on the vertical support profiles (2) is automatically latched, wherein the hook during mounting of the variable support (1) is inserted from the inside through an opening (3) of the support profile (2) and in the mounted state engages behind the periphery of the opening (3).

2. Variable support (1) according to Claim 1, **characterized in that** the variable support (1) on the end side has at least one centring element which engages from the inside into the opening (3) of the vertical support profile (2) of the rack.

3. Variable support (1) according to Claim 2, **characterized in that** the centring element is configured as a horizontal sheet-metal tab (4) of the variable support (1).

4. Variable support (1) according to Claim 2, **characterized in that** the centring element is configured as a vertical sheet-metal tab (6) of the variable support (1).

5. Variable support (1) according to Claim 2, **characterized in that** the centring element is configured as a round centring bolt of the variable support (1).

6. Variable support (1) according to Claim 2, **characterized in that** the centring element is configured as a hollow centring bolt (10) of the variable support, and that the latching installation is partly disposed within the centring bolt (10).

7. Variable support (1) according to one of the preceding claims, **characterized in that** the spring-loaded hook (5) has an unlocking protrusion (9), such that the hook (5) can be unlocked from the front side of the support profile through an opening (3).

8. Variable support (1) according to one of the preceding claims, **characterized in that** the latching installation has two hooks (5) which are perpendicularly opposite one another and which are biased by a common spring (8).

9. Variable support (1) according to one of Claims 1 to 7, **characterized in that** the latching installation has two hooks (5) which are perpendicularly on top of one another, having a horizontal direction of movement of the hooks relative to the variable support (1).

## Revendications

1. Support variable (1) pour le montage sur un profilé de support vertical (2) d'une étagère, les profilés de support verticaux (2) de l'étagère présentant des ouvertures (3) suivant une trame standardisée et le support variable (1) pouvant être fixé aux profilés de support verticaux (2) par le biais des ouvertures (3), **caractérisé en ce que**
le support variable (1) présente un dispositif d'encliquetage qui est réalisé sous forme de crochets (5) précontraints par ressort et qui s'encliquète automatiquement lors de l'enfoncement dans l'une des ouvertures (3) sur les profilés de support verticaux (2), le crochet, lors du montage du support variable (1), étant enfiché par l'intérieur à travers une ouverture (3) du profilé de support (2) et venant en prise, dans l'état monté, par l'arrière avec le bord de l'ouverture (3).

2. Support variable (1) selon la revendication 1,
**caractérisé en ce que**
le support variable (1) présente du côté frontal au moins un élément de centrage qui vient en prise par l'intérieur dans l'ouverture (3) du profilé de support vertical (2) de l'étagère.

3. Support variable (1) selon la revendication 2,
**caractérisé en ce que**
l'élément de centrage est réalisé sous forme de patte en tôle horizontale (4) du support variable (1).

4. Support variable (1) selon la revendication 2,
**caractérisé en ce que**
l'élément de centrage est réalisé sous forme de patte en tôle verticale (6) du support variable (1).

5. Support variable (1) selon la revendication 2,
**caractérisé en ce que**
l'élément de centrage est réalisé sous forme de boulon de centrage rond du support variable (1).

6. Support variable (1) selon la revendication 2,
**caractérisé en ce que**
l'élément de centrage est réalisé sous forme de boulon de centrage creux (10) du support variable et le dispositif d'encliquetage est disposé en partie à l'intérieur du boulon de centrage (10).

7. Support variable (1) selon l'une quelconque des revendications précédentes,
**caractérisé en ce que**
le crochet précontraint (5) présente une saillie de déverrouillage (9) de sorte que le crochet (5) puisse être déverrouillé depuis le côté avant du profilé de support à travers une ouverture (3).

8. Support variable (1) selon l'une quelconque des revendications précédentes,
**caractérisé en ce que**
le dispositif d'encliquetage présente deux crochets (5) opposés verticalement, qui sont précontraints par un ressort commun (8).

9. Support variable (1) selon l'une quelconque des revendications 1 à 7,
**caractérisé en ce que**
le dispositif d'encliquetage présente deux crochets (5) verticalement l'un au-dessus de l'autre avec une direction de déplacement horizontale des crochets par rapport au support variable (1).
